# EUROPÄISCHE PATENTSCHRIFT

(11) **EP 1 046 198 B1**
(45) Veröffentlichungstag und Bekanntmachung des Hinweises auf die Patenterteilung: **10.04.2002**
(21) Anmeldenummer: 98966987.4
(22) Anmeldetag: 28.12.1998
(51) Int. Cl.: H01R 3/00

(54) **ELEKTRISCHE STECKVERBINDUNG**
ELECTRIC CONNECTOR
CONNECTEUR ELECTRIQUE

(30) Priorität: 10.01.1998 DE 19800707
(43) Veröffentlichungstag der Anmeldung: 25.10.2000
(73) Patentinhaber: Siemens Aktiengesellschaft, 80333 München (DE)
(72) Erfinder: BENDER, Günther, D-61191 Rodheim (Rosbach) (DE)
(74) Vertreter: Rassler, Andrea, Dipl.-Phys.
(86) Internationale Anmeldenummer: EP9808481
(87) Internationale Veröffentlichungsnummer: WO9935712

(56) Entgegenhaltungen:
- EP-A- 0 596 392
- WO-A-95/34106
- US-A- 5 131 362
- US-A- 5 481 141
- US-A- 5 672 818

## Beschreibung

Die Erfindung befaßt sich mit einer elektrischen Verbindung zwischen einem Potentiometer zur Erfassung der Ist-Stellung eines Stellgliedes, einem Motor zur Betätigung des Stellgliedes und einer Regelelektronik zur Steuerung des Soll-/Istwertabgleiches.

Eine derartige elektrische Verbindung benötigt man zum Beispiel bei sogenannten E-Gasanlagen in Kraftfahrzeugen. Das Potentiometer ist dabei mit der Drosselklappenwelle des Motors gekoppelt, die durch Betätigen des Stellmotors verdrehbar ist. Die Regelelektronik vergleicht dabei den durch die Gaspedalstellung vorgegebenen Sollwert mit dem durch das Potentiometer ermittelten Istwert der Drosselklappenstellung und führt gegebenenfalls Korrekturmaßnahmen durch Ansteuern des Stellmotors durch. Die elektrischen Bauelemente des Regelkreises sind bisher über Kabel miteinander verbunden, wozu eine Vielzahl von Kontaktierungsstellen notwendig ist. Neben beispielsweise durch Schweißen oder Löten hergestellten starren Verbindungen bestehen die Kontaktierungsstellen aus durch Crimpen hergestellten Verbindungen oder Steckverbindungen. Mit jeder zusätzlichen Kontaktierungsstelle erhöht sich jedoch das Risiko von Kontaktierungsproblemen, unabhängig von der konstruktiven Ausgestaltung. Bei den starren Verbindungen besteht die Gefahr, daß sie infolge unterschiedlicher Wärmeausdehnungskoeffizienten der miteinander verbundenen Materialien bei Temperaturschwankungen, wie sie zum Beispiel im Motorraum eines Kraftfahrzeuges in erheblichem Umfang auftreten, mit der Zeit zerstört werden können. Bei den übrigen Verbindungen treten Probleme durch Oxidation der Kontaktflächen auf oder die Übergangswiderstände zwischen den Kontaktflächen sind aufgrund von bereits anfänglich zu geringer oder während des Einsatz nachlassender mechanischer Vorspannung der beiden Kontaktpartner sehr hoch. Auch die geringer werdende Strombelastbarkeit derartiger Verbindungen unter dem Einfluß hoher Temperaturen (Derating-Kurve) muß beachtet werden.

Das Herstellen der Kontaktierungsstellen erfordert auch eine Vielzahl von Arbeitsvorgängen, die zum Teil nur schwer automatisierbar sind und jeder für sich das Risiko eines Prozeßfehlers bergen. Ein weiterer Nachteil mechanischer Verbindungen besteht darin, daß die Kabel, Steckerbuchsen und Steckergehäuse schwingungsempfindliche Bauteile darstellen, die sich insbesondere bei den im Motorenbereich von Kraftfahrzeugen stets vorhandenen Vibrationen mit der Zeit lösen können.

Eine elektrische Verbindung gemäß dem Oberbegriff des Auspruchs 1 ist in US-A-5 672 818 offenbart. Die Aufgabe der Erfindung besteht darin, die für eine elektrische Verbindung der eingangs genannten Art notwendigen Kontaktierungsstellen zu vermindern und damit die Ausfallsicherheit zu verbessern sowie die Fertigungskosten zu senden.

Erfindungsgemäß wird die Aufgabe durch eine elektrische Verbindung der eingangs genannten Art gelöst, bei welcher das Trägersubstrat des Potentiometers und die Kontaktplatte des Motors als einstückige Platte ausgebildet sind und die elektrischen Verbindungen wenigstens zum Teil aus in das Substrat eingebetteten Leiterbahnen bestehen.

Damit kann eine Vielzahl von Kontaktierungsstellen entfallen. Das Risiko von Fehlern bei der Herstellung der elektrischen Verbindung wird durch die in das Substrat eingebetteten Leiterbahnen verringert. Auch gegenüber Vibrationen und Temperaturschwankungen hat sich die erfindungsgemäße elektrische Verbindung als sehr widerstandsfähig erwiesen. Der Anschluß des Motors und des Potentiometers an die Regelelektronik kann beispielsweise über eine einzige Steckverbindung an der Platte erfolgen. Eine getrennte Verdrahtung von Potentiometer und Motor wird vermieden.

In weiterer Ausgestaltung der Erfindung ist vorgesehen, daß auf der Platte wenigstens ein Teil der elektrischen Bauteile des aus dem Potentiometer, dem Motor und der Regelelektronik bestehenden Regelkreises integriert ist. So können zum Beispiel im Bereich des Motors Drosseln, Kohlelitzenkontaktierungen oder aufgedruckte Ableitwiderstände vorgesehen sein. Auch die Bahnen des Potentiometers sind vorzugsweise durch Bedrucken unmittelbar auf die Platte aufgebracht und stehen mit den eingebetteten Leiterbahnen in Verbindung. Durch diese Maßnahmen ist eine weitere Reduzierung bisher notwendiger Kontaktierungsstellen möglich.

Neben einer Kontaktstelle zum Anschluß der Regelelektronik können weitere Anschlußstellen für Kontaktfahnen des Motors vorgesehen sein. Als Alternative zur Motorkontaktstelle besteht die Möglichkeit, die Platte im Bereich des Motors unmittelbar mit Kohleführungsschächten auszubilden.

In bevorzugter Weiterbildung der Erfindung sind an den Kontaktstellen Öffnungen vorgesehen, in welche die Leiterbahnen von wenigstens zwei gegenüberliegenden Seiten elastisch zungenförmig ragen, wobei der Abstand der Zungenenden voneinander kleiner ist als der Durchmesser oder die Breite des einzusteckenden Kontaktstiftes beziehungsweise der einzusteckenden Kontaktfahne.

Diese Art der Kontaktierung führt trotz des einfachen Einsteckens der Stifte beziehungsweise der Kontaktfahnen zu einer sehr guten elektrischen Verbindung, da die elastischen Zungen zunächst durch die Kontaktstifte elastisch aufgebogen werden und anschließend mit ihrer Kante federnd an der Oberfläche des Kontaktstiftes anliegen. Die hierbei entstehende sehr hohe Flächenpressung sorgt für eine elektrisch einwandfreie Kontaktierung mit geringem Übergangswiderstand. Da eine Zugkraft auf den Kontaktstift die Anpreßkraft der Leiterbahnenzungen an der Stiftoberfläche erhöht, bildet eine derartige Verbindung gleichzeitig einen sicheren Schutz vor einem Lösen des Steckers infolge von Vibrationen. Andererseits führen Materialausdehnungen infolge unterschiedlicher Wärmeeinflüsse nicht zu einem Zerstören der Verbindung, da die Kontaktzungen der Leiterbahnen eine gewisse Elastizität besitzen.

Da in den verschiedenen Bereichen der Platte unterschiedliche Anforderungen an die Leiterbahnen gestellt werden, ist in weiterer bevorzugter Ausführungsform der Erfindung vorgesehen, daß die Leiterbahnen in ihren einzelnen Bereichen aus verschiedenen Werkstoffen bestehen. So kann die Leiterbahn im Bereich der zuvor beschriebenen Kontaktstelle aus einem federelastischen Material bestehen, das für eine dauerhafte elastische Anlage an dem eingesteckten Kontaktstift sorgt.

Die Platte kann zwischen dem Motorbereich und dem Potentiometerbereich eine Sollbruchstelle aufweisen, wobei die die beiden Teile verbindenden Leiterbahnen im Bereich der Sollbruchstelle freiliegend und biegsam sind.

Die Ausführungsform mit der Sollbruchstelle ermöglicht es, die Motorpiatte vor der eigentlichen Montage der übrigen Platte zu lösen und so den räumlichen Gegebenheiten besser anzupassen. Die elektrische Verbindung zwischen den beiden Plattenteilen bleibt dadurch unberührt. Neben dem Ausgleich von Toleranzen kann der Motor auch in Bezug auf das Potentiometer geneigt oder senkrecht dazu stehend angeordnet sein, wobei allerdings auf eine ausreichende Deformierbarkeit der freiliegenden Leiterbahnen zu achten ist.

Nachfolgend wird anhand der beigefügten Zeichnungen näher auf ein Ausführungsbeispiel der Erfindung eingegangen.

Es zeigen:
- Figur 1:: eine Schrägansicht einer elektrischen Verbindung in Form einer Platte;
- Figur 2/3:: einen Schnitt der Platte nach Figur 1 im Bereich einer Steckverbindung.

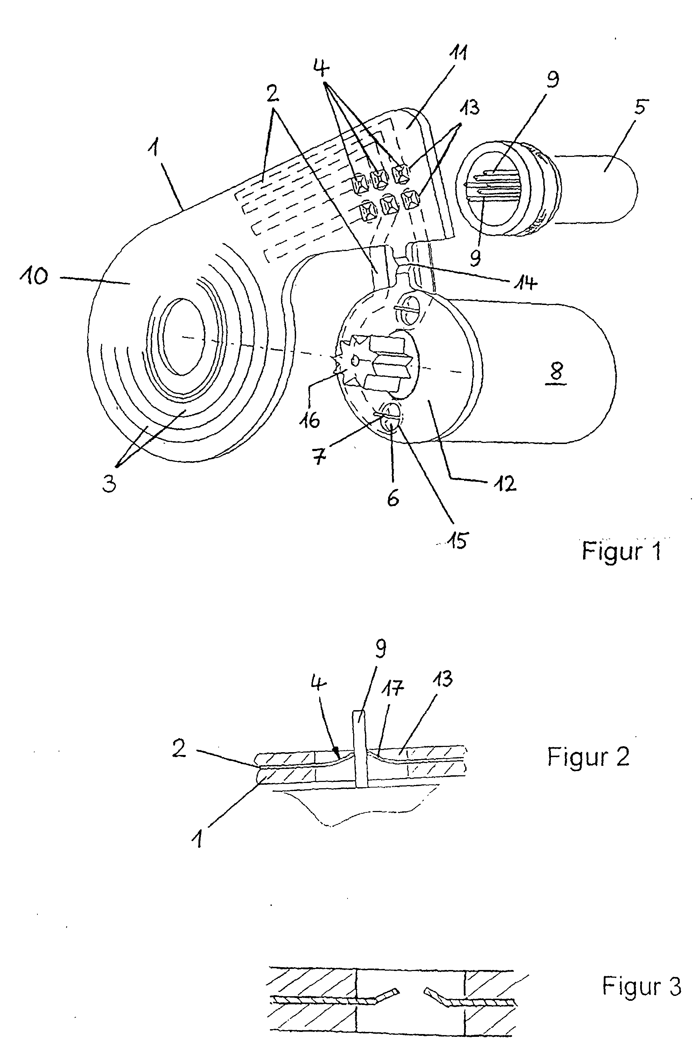

Figur 1 zeigt eine Trägerplatte 1, die über in ihre Substratschicht eingelegte Leiterbahnen 2 verfügt und damit eine elektrische Verbindung zwischen Bahnen 3 eines Potentiometers (nicht gezeigt), Steckkontakten 4 zum Einstecken eines Steckers 5 und Steckkontakten 6 zum Einstecken von Kontaktfahnen 7 eines Motors 8 bildet. Der Stecker 5 mit seinen Kontaktstiften 9 verbindet die Steckkontakte 4 der Leiterbahnen 2 mit einer Regelelektronik (nicht gezeigt), die anhand eines Vorgabewertes über den Motor 8 ein Stellglied (nicht gezeigt) betätigt. Das Potentiometer dient zur Erfassung der Ist-Stellung des Stellgliedes, so daß die Regelelektronik einen Ist-/Sollwertabgleich vornehmen und den Motor 8 gegebenenfalls nachregulieren kann. Ein derartiger Regelkreis findet beispielsweise bei sogenannten E-Gasanlagen in Kraftfahrzeugen Verwendung, bei denen entsprechend der Fahrpedalstellung die Drosselklappe im Ansaugkanal des Motors als Stellglied elektronisch betätigt wird.

Die Trägerplatte 1 gliedert sich im wesentlichen in drei Bereiche 10, 11, 12. Der erste Bereich 10 entspricht im wesentlichen dem Substrat eines Potentiometers, auf dessen Oberfläche die Bahnen 3 aufgedruckt sind. Der zweite Bereich 11, der als Kontaktbereich bezeichnet werden soll, ist seitlich an den ersten Bereich 10 angeformt. Die Leiterbahnen 2 sind als Einlegeset im freigestanzten Spinnenaufbau in die Substratschicht der Trägerplatte 1 eingebettet und enden im Bereich der sechs Steckkontakte 4 in Durchgangsöffnungen 13 (siehe auch Figur 2) in der Trägerplatte 1. Vier der Leiterbahnen 2 führen zu dem Potentiometer und stehen mit den aufgedruckten Bahnen 3 in Verbindung. Eine Motorkontaktplatte 12, die den dritten Bereich der Trägerplatte 1 bildet, ist über eine Sollbruchstelle 14 an dem Kontaktbereich 12 der Trägerplatte 1 angeformt. Zwei Leiterbahnen 2 führen von den Steckkontakten 4 freiliegend neben der Sollbruchstelle 14 zur Motorkontaktplatte 12 und bilden dort in geeignet angeordneten Öffnungen 15 die Steckkontakte 6 für die Kontaktfahnen 7 des Motors 8. Die freiliegenden Bereiche der Leiterbahnen 2 sind elastisch ausgebildet.

Der Motor 8 treibt über ein Ritzel 16 ein Stellglied an, zum Beispiel die Drosselklappe eines Motors, das wiederum mit dem Potentiometer (nicht gezeigt) verbunden ist. Die Sollbruchstelle 14 dient dazu, die Motorkontaktplatte 12 mechanisch vom Rest der Trägerplatte 1 lösen zu können, so daß man bei der Montage größere Freiheiten für die Anordnung des Motors 8 erhält, ohne daß dadurch die elektrische Verbindung unterbrochen werden müßte.

Der Aufbau der Steckkontakte 4, 7 ergibt sich aus dem in Figur 2 dargestellten Querschnitt. Dieser verdeutlicht die Lage der Leiterbahnen 2, die von dem Substrat der Trägerplatte 1 vollständig eingebettet sind. Im Bereich der Steckkontakte 4 ragen die Leiterbahnen 2 mit elastischen Kontaktzungen 17 von wenigstens zwei Seiten in die Öffnungen 13. Bei zwei Kontaktzungen 17 liegen sich die beiden Kontaktzungen unmittelbar gegenüber, während zum Beispiel bei drei Kontaktzungen eine versetzte Anordnung um 120° zueinander vorteilhaft ist. Eine Anordnung von vier Kontaktzungen, wie im Bereich der Steckkontakte 4, bietet den Vorteil einer noch besseren elektrischen Kontaktierung.

Der Abstand der gegenüberliegenden Kontaktzungen 17 ist kleiner als der Durchmesser der Kontaktstifte 9 beziehungsweise der Kontaktfahnen 7 des Motors 8. Beim Einschieben eines Kontaktstiftes 9 werden die Kontaktzungen 17 daher in der in Figur 2 dargestellten Weise aufgebogen, bis der Kontaktstift 9 zwischen den Kontaktzungen 17 durchführbar ist. Die Elastizität der Kontaktzungen 17 bewirkt dabei eine sehr feste Anlage ihrer Enden an der Außenseite des Kontaktstifts 9. Die Kante der Kontaktzungen 17 verkantet dabei mit dem Kontaktstift 9. Bei einem Zurückziehen des Kontaktstifts 9 kann zwischen den Kontaktzungen 17 und der Oberfläche des Kontaktstiftes keine Relativbewegung stattfinden, sondern die Kanten der Kontaktzungen schneiden in die Oberfläche ein. Damit besitzt die Kontaktierungsstelle eine sichere Klemmwirkung, die verhindert, daß der Stecker 5 unter Vibrationen aus den Steckkontakten 4 herausfallen kann. Beim Auftreten von Temperaturschwankungen sorgt die Elastizität der Kontaktzungen 17 dafür, daß temperaturbedingte Materialausdehnungen kompensiert werden und nicht zu einer Verschlechterung oder Zerstörung der Kontaktierungsstelle führen können. Ein Verlöten der Kontaktflächen ist nicht erforderlich.

In die Motorkontaktplatte 12 können zu einer weiteren Verringerung von Kontaktstellen und Montagevereinfachung elektrische Bauelemente, wie zum Beispiel eine elektrische Drossel zur Funkentstörung des Motors, integriert sein. Auch die Ausbildung von Kohleführungsschächten für den Motor 8 unmittelbar in der Motorkontaktplatte 12 ist ohne weiteres realisierbar.

Figur 3 zeigt eine weitere Möglichkeit, die Zungen 17 schon vor dem Einsetzen der Kontaktstifte 9 vorzubiegen, um mit dieser Ausgestaltung eine Montageerleichterung zu erzielen.

### Bezugszeichenliste:

- 1.: Trägerplatte
- 2.: Leiterbahnen
- 3.: Bahnen
- 4.: Steckkontakte
- 5.: Stecker
- 6.: Steckkontakte
- 7.: Kontaktfahnen
- 8.: Motor
- 9.: Kontaktstifte
- 10.: Bereich
- 11.: Bereich
- 12.: Bereich
- 13.: Durchgangsöffnung
- 14.: Sollbruchstelle
- 15.: Öffnungen
- 16.: Ritzel
- 17.: Kontaktzungen

## Patentansprüche

1. Elektrische Verbindung zwischen einem Potentiometer zur Erfassung der Ist-Stellung eines Stellgliedes, einem Motor (8) zur Betätigung des Stellgliedes und einer Regelelektronik zur Steuerung des Soll-/Istwertabgleiches, wobei das Trägersubstrat des Potentiometers und die Kontaktplatte (12) des Motors (8) als einstückige Platte (1) ausgebildet sind und die elektrischen Verbindungen wenigstens zum Teil aus in das Trägersubstrat eingebetteten Leiterbahnen (2) bestehen **dadurch gekennzeichnet, daß** die Platte (1) zwischen dem Bereich der Motorkontaktplatte (12) und dem Potentiometerbereich (10) eine Sollbruchstelle (14) aufweist und die die beiden Teile verbindenden Leiterbahnen (2) im Bereich der Sollbruchstelle (14) freiliegend und biegsam sind.

2. Elektrische Verbindung nach Anspruch 1 **dadurch gekennzeichnet, daß** auf der Platte (1) wenigstens ein Teil der elektrischen Bauteile des aus Potentiometer, Motor (8) und Regelelektronik bestehenden Regelkreises integriert ist.

3. Elektrische Verbindung nach Anspruch 1 oder 2 **dadurch gekennzeichnet, daß** die Bahnen (3) des Potentiometers durch Bedrucken auf die Platte (1) aufgebracht sind und mit den eingebetteten Leiterbahnen (2) in Verbindung stehen.

4. Elektrische Verbindung nach einem der Ansprüche 1 bis 3 **dadurch gekennzeichnet, daß** die Platte (1) in ihrem Kontaktbereich (11) mit Kontaktstellen (4, 6) zum Anschließen von Kontaktfahnen (7) des Motors (8) und/oder einer Steckverbindung (5, 9) der Regelelektronik versehen ist

5. Elektrische Verbindung nach Anspruch 4, **dadurch gekennzeichnet, daß** an den Kontaktstellen (4, 6) Öffnungen (13, 15) in der Platte (1, 11, 12) vorgesehen sind, in welche die Leiterbahnen (2) von wenigstens zwei gegenüberliegenden Seiten elastisch zungenförmig ragen, wobei der Abstand der Enden der Kontaktzungen (17) kleiner ist als der Durchmesser beziehungsweise die Breite des einzusteckenden Stiftes (9) beziehungsweise der einzusteckenden Kontaktfahne (7).

6. Elektrische Verbindung nach einem der vorhergehenden Ansprüche, **dadurch gekennzeichnet, daß** die Leiterbahnen (2) in ihren einzelnen Bereichen aus verschiedenen Werkstoffen bestehen.

7. Elektrische Verbindung nach einem der vorhergehenden Ansprüche, **dadurch gekennzeichnet, daß** die Platte (1) im Bereich des Motors (8) Kohleführungsschächte für den Motor (8) aufweist.

## Claims

1. Electrical connection between a potentiometer for detecting the actual position of an actuating element, a motor (8) for operating the actuating element and control electronics for controlling the nominal/actual value correction, in which case the base substrate of the potentiometer and the contact board (12) of the motor (8) are in the form of an integral board (1), and at least some of the electrical connections comprise conductor tracks (2) embedded in the base substrate, **characterized in that** the board (1) has a weak point (14) between the region of the motor contact board (12) and the potentiometer region (10), and the conductor tracks (2) which connect the two parts are exposed and flexible in the region of the weak point (14).

2. Electrical connection according to Claim 1, **characterized in that** at least some of the electrical components of the control loop which comprises the potentiometer, motor (8) and control electronics are integrated on the board (1).

3. Electrical connection according to Claim 1 or 2, **characterized in that** the tracks (3) of the potentiometer are applied to the board (1) by printing and are connected to the embedded conductor tracks (2).

4. Electrical connection according to one of Claims 1 to 3, **characterized in that,** in its contact region (11), the board (1) is provided with contact points (4, 6) for the connection of contact tabs (7) of the motor (8) and/or of a plug connection (5, 9) for the control electronics.

5. Electrical connection according to Claim 4, **characterized in that,** at the contact points (4, 6), openings (13, 15) are provided in the board (1, 11, 12), into which openings the conductor tracks (2) project elastically in the form of tongues from at least two opposite sides, with the distance between the ends of the contact tongues (17) being less than the diameter or the width of the pin (9) to be inserted or of the contact tab (7) to be inserted.

6. Electrical connection according to one of the preceding claims, **characterized in that** the conductor tracks (2) are composed of different materials in their individual regions.

7. Electrical connection according to one of the preceding claims, **characterized in that** the board (1) has brush guide channels for the motor (8) in the region of the motor (8).

## Revendications

1. Connexion électrique entre un potentiomètre, servant à détecter la position réelle d'un organe de réglage, un moteur (8), servant à actionner l'organe de réglage, et une électronique de régulation servant à commander l'égalisation valeur de consigne/valeur réelle, le substrat de support du potentiomètre et la plaquette de contact (12) du moteur (8) étant réalisés sous forme d'une plaquette (1) d'une seule pièce et les connexions électriques étant constituées au moins en partie de pistes conductrices (2) noyées dans le substrat de support, **caractérisée en ce que** la plaquette (1) comporte un emplacement de rupture imposée (14) entre la zone de la plaquette de contact de moteur (12) et la zone de potentiomètre (10), tandis que les pistes conductrices (2) reliant les deux parties sont à l'état libre et souples dans la zone de l'emplacement de rupture imposée (14).

2. Connexion électrique suivant la revendication 1, **caractérisée en ce qu'**au moins une partie des composants électriques du circuit de régulation constitué du potentiomètre, du moteur (8) et de l'électronique de régulation est intégrée sur la plaquette (1).

3. Connexion électrique suivant la revendication 1 ou 2, **caractérisée en ce que** les pistes (3) du potentiomètre sont appliquées par impression sur la plaquette (1) et sont en liaison avec les pistes conductrices (2) noyées.

4. Connexion électrique suivant l'une des revendications 1 à 3, **caractérisée en ce que**, dans sa zone de contact (11), la plaquette (1) est pourvue d'emplacements de contact (4, 6) servant au raccordement de bornes plates de contact (7) du moteur (8) et/ou d'une connexion à enfichage (5, 9) de l'électronique de régulation.

5. Connexion électrique suivant la revendication 4, **caractérisée en ce qu'**à l'endroit des emplacements de contact (4, 6), il est prévu, dans la plaquette (1, 11, 12), des ouvertures (13, 15) dans lesquelles les pistes conductrices (2) font saillie en forme de languette, à comportement élastique, à partir d'au moins deux côtés se faisant face, la distance des extrémités des languettes de contact (17) étant inférieure au diamètre ou à la largeur de broche respectivement de la broche à enficher (9) ou de la borne plate de contact (7) à enficher.

6. Connexion électrique suivant l'une des revendications précédentes, **caractérisée en ce que** les pistes conductrices (2) sont constituées de matières différentes dans les différentes zones.

7. Connexion électrique suivant l'une des revendications précédentes, **caractérisée en ce que** la plaquette (1) comporte, dans la zone du moteur (8), des puits de passage de balai prévus pour le moteur (8).
